# DEMANDE DE BREVET EUROPEEN

(11) **EP 2 323 160 A1**
(43) Date de publication de la demande: **18.05.2011**
(21) Numéro de dépôt: 10354071.2
(22) Date de dépôt: 04.11.2010
(51) Int. Cl.: H01L 21/336, H01L 29/786, H01L 21/84, H01L 27/12

(54) **Procédé de réalisation de transistors à effet de champs avec une contre-électrode et dispositif semi-conducteur**

(30) Priorité: 12.11.2009 FR 0905438
(71) Demandeur: Commissariat à l'Énergie Atomique et aux Énergies Alternatives, 75015 Paris (FR)
(72) Inventeur: Fenouillet-Beranger, Claire, 38400 Saint Martin d'Hères (FR); Coronel, Philippe, 38530 Barraux (FR)
(74) Mandataire: de Jong, Jean Jacques

(57) **Abrégé**

Le procédé de réalisation d'un transistor à effet de champ sur un substrat comprenant une couche de support 1, une couche sacrificielle et une couche semi-conductrice 3 comprend la formation d'une zone active dans la couche semi-conductrice. La zone active est délimitée par un motif d'isolation périphérique fermé 6 et comporte un motif additionnel 15 dans un matériau isolant. Le procédé comporte également la gravure du matériau isolant du motif additionnel pour accéder à la couche sacrificielle, la gravure de la couche sacrificielle d'où il résulte la formation d'une première cavité, la formation d'une couche diélectrique 11 sur une paroi supérieure de la première cavité, et le dépôt d'une couche électriquement conductrice 5 dans la première cavité. Le motif d'isolation 6 est formé au travers de la couche semi-conductrice 3 et de la couche sacrificielle.

## Description

### Domaine technique de l'invention

L'invention concerne un procédé de réalisation d'un transistor à effet de champ sur un substrat comprenant une couche de support, une couche sacrificielle et une couche semi-conductrice. Le procédé comprend la formation d'une zone active dans la couche semi-conductrice, la zone active étant délimitée par un motif d'isolation périphérique fermé et comportant un motif additionnel dans un matériau isolant, la gravure du matériau isolant du motif additionnel pour accéder à la couche sacrificielle, la gravure de la couche sacrificielle d'où il résulte la formation d'une première cavité, la formation d'une couche diélectrique sur une paroi supérieure de la première cavité, et le dépôt d'une couche électriquement conductrice dans la première cavité.

L'invention concerne également un dispositif semi-conducteur comportant une pluralité de transistors sur un substrat, chaque transistor étant formé sur une zone active et étant associé à un plan de masse.

### État de la technique

Les transistors intégrés sur un substrat de type semi-conducteur sur isolant (« Silicon on insulator » en anglais, SOI) présentent généralement de meilleures performances que les transistors intégrés sur un substrat massif (« Bulk ») notamment en terme de consommation. Il est également reconnu qu'un transistor SOI est plus résistant aux effets de canaux courts qu'un transistor conventionnel sur substrat massif. Cependant, le transistor SOI souffre de l'effet de corps flottant, résultant de l'accumulation de charges électriques dans le corps du transistor, c'est-à-dire la région du canal du transistor. De ce fait, les tensions de seuil d'un tel transistor sont souvent difficiles à contrôler. Pour remédier à ce problème, un transistor complètement déplété est utilisé. Dans ce cas, la zone de déplétion du transistor occupe toute l'épaisseur de la couche semi-conductrice formant le canal.

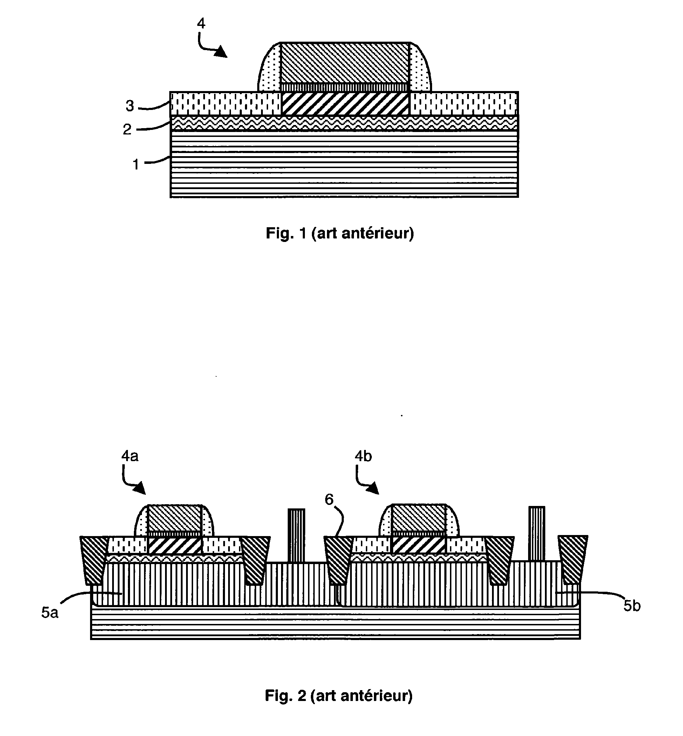

La figure 1 représente un transistor à effet de champ complètement déplété sur un substrat SOI. Le substrat SOI comporte successivement une couche de support 1, une couche d'isolant enterré 2 et une couche semi-conductrice 3. Le transistor 4 est formé dans la couche semi-conductrice 3.

De plus, il est préférable de placer une contre-électrode sous la couche d'isolant enterré afin de moduler le corps du transistor et ainsi optimiser !e contrôle du canal par la grille, tout en réduisant davantage les effets de canaux courts. La contre-électrode est généralement formée par un matériau semi-conducteur dopé, de type n ou p, disposé sous la couche d'isolant enterré au niveau du canal et/ou des régions de drain et de source. Un contact sur la contre-électrode est nécessaire afin d'appliquer un potentiel et ainsi faire varier la tension de seuil du transistor.

La figure 2 représente deux transistors, 4a et 4b, comportant chacun une contre-électrode, respectivement noté 5a et 5b. Les transistors sont formés à partir d'un même substrat de type SOI. Les contre-électrodes sont réalisées, par exemple, par une zone dopée de type P sous un transistor NMOS et une zone dopée de type N sous un transistor PMOS. Les zones dopées sont formées dans le substrat de support et le contact de la contre-électrode (la zone dopée) est formé sur la même face du substrat que les transistors MOS. Les transistors sont, de manière classique, isolés entre eux par des motifs d'isolation 6, par exemple des tranchées peu profondes STI (« Shallow Trench Isolation »). Des tranchées peuvent également être utilisées pour séparer la contre-électrode ou la prise de contact de la couche semi-conductrice.

L'augmentation continue des performances des circuits intégrés, par exemple, en termes de consommation et/ou de fréquence de fonctionnement, se traduit inéluctablement par une diminution constante de la taille de ses composants. La diminution des dimensions entraîne alors des problèmes d'isolation entre les contre-électrodes 5a et 5b. Les tranchées 6 ne suffisent plus pour assurer cette isolation.

Les figures 3 à 5 représentent des étapes d'un procédé décrit dans le document US2009/0212362. Ce procédé permet d'obtenir un transistor 4 à effet de champ sur un substrat SOI. Le transistor 4 comprend une contre-électrode 5 isolée électriquement de la couche semi-conductrice 3 et des autres contre-électrodes éventuelles par une couche diélectrique 11.

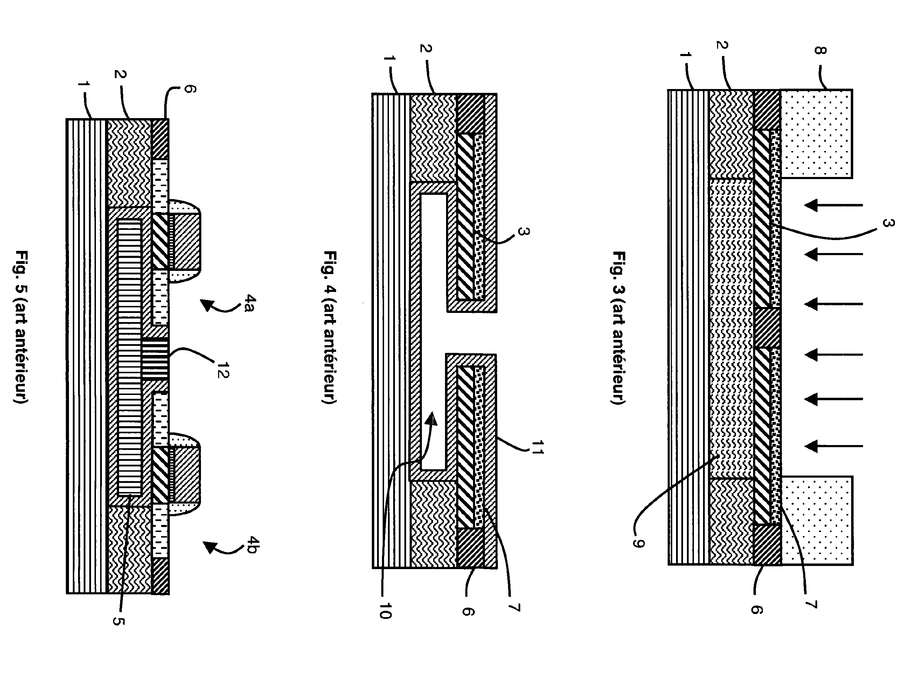

Le procédé comporte notamment la formation de motifs d'isolation 6 en forme de tranchées dans la couche semi-conductrice 3 d'un substrat SOI. Les motifs 6 sont, par exemple, en oxyde de silicium et le substrat SOI peut être recouvert d'une couche de protection 7 (figure 3). Les motifs 6 définissent des zones actives destinées à recevoir les transistors. Le procédé comporte également une étape d'implantation ionique à travers un masque 8, préalablement défini pendant une étape de photolithographie spécifique. L'implantation, d'ions de germanium par exemple, dégrade une portion 9 d'isolant enterré en modifiant la composition chimique et/ou la structure de la couche d'isolant enterré 2. Cette portion 9 d'isolant endommagé peut alors être gravée plus rapidement que le reste de la couche d'isolant enterré 2.

Un motif d'isolation 6, situé au-dessus de la portion d'isolant dégradé 9, est supprimé par gravure, comme représenté sur la figure 4. Dans le cas d'un motif en oxyde de silicium, la gravure peut être réalisée par voie humide, avec une solution d'acide fluorhydrique (HF) par exemple. La portion d'isolant dégradé 9 est également gravée en grande partie en utilisant la même chimie. Une seconde gravure, sélective par rapport à la couche d'isolant enterré 2, est utilisée pour éliminer la totalité de la portion 9 et former une cavité 10.

Une couche diélectrique 11 est ensuite formée sur les faces libres de la cavité 10 et de la couche de protection 7. La couche diélectrique 11 est suffisamment épaisse pour assurer l'isolation électrique entre la couche semi-conductrice 3 et la contre-électrode réalisée ultérieurement dans la cavité 10.

Comme représenté à la figure 5, la contre-électrode 5 est formée dans la cavité par dépôt d'un matériau conducteur, un métal par exemple, ou un semi-conducteur dopé, le silicium polycristallin notamment. Enfin, un bouchon 12 en matériau diélectrique est déposé sur la contre-électrode 5, dans l'ouverture correspondant au motif d'isolation gravé.

Les transistors 4a et 4b sont ensuite formés sur la face supérieure de la couche semi-conductrice, de part et d'autre du bouchon 12, dans chacune des zones actives délimitées par les motifs d'isolation 6 et le bouchon 12. La contre-électrode 5 est commune aux deux transistors 4a et 4b dans ce mode de réalisation.

Dans une variante de réalisation, chaque contre-électrode peut être dédiée à un transistor. La contre-électrode s'étend sous le canal d'au moins un transistor. Elle peut également être située sous la source et une partie du drain du transistor.

Dans une étape ultérieure du procédé (non représentée sur les figures), les contacts de source et de drain des transistors 4a et 4b, ainsi que le contact de la contre-électrode 5, sont formés à travers une couche diélectrique d'interconnexion. De plus, le contact de la contre-électrode 5 traverse le bouchon 12.

Ce procédé permet donc la formation de transistors avec une contre-électrode électriquement indépendante. Cependant, un tel procédé est long et difficile à mettre en oeuvre. De plus, ce procédé est particulièrement sensible aux problèmes de contamination métallique lorsque la contre-électrode est en métal et est incompatible avec la formation d'une contre-électrode associée à un ou plusieurs transistors et qui s'étend sous toute la zone active efficace du transistor.

### Objet de l'invention

L'invention a pour but un procédé de réalisation de transistors MOSFET simple et facile à mettre en oeuvre, comprenant un nombre limité d'étapes de photolithographie et qui autorise si nécessaire le parfait recouvrement entre la contre-électrode et les zones actives associées à la contre-électrode.

Selon l'invention, ce but est atteint par le fait que le motif d'isolation est formé au travers de la couche semi-conductrice et de la couche sacrificielle.

L'invention a également pour but un dispositif semi-conducteur fiable présentant une pluralité de transistors, chaque transistor étant associé à un plan de masse, tout en réduisant les risques de fuites entre les plans de masse.

Selon l'invention, ce but est atteint par le fait que la zone active et le plan de masse sont délimités par un même motif d'isolation périphérique fermé et par le fait que le dispositif comporte, pour chaque transistor, un motif additionnel à l'intérieur de la surface délimitée par le motif périphérique fermé pour former un contact du plan de masse.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un transistor intégré sur un substrat SOI selon l'art antérieur,
- la figure 2 représente, de manière schématique, deux transistors sur un substrat SOI comprenant des contre-électrodes selon l'art antérieur,
- les figures 3 à 5 représentent, de manière schématique, des étapes d'un procédé de réalisation de transistors avec contre-électrode selon l'art antérieur,
- la figure 6 représente, de manière schématique, un substrat de départ selon l'invention,
- les figures 7 et 8 représentent, de manière schématique et en vue de dessus, des modes de réalisation particuliers selon l'invention,
- les figures 9 à 18 représentent, de manière schématique et en vue de coupe selon l'axe A-A, des étapes d'un procédé selon un mode de réalisation des figures 7 et 8,
- les figures 19 à 21 représentent, de manière schématique et en vue de coupe selon A-A, des étapes d'une variante de réalisation d'un procédé selon l'invention, correspondant aux étapes des figures 13 à 15,
- la figure 22 représente, de manière schématique et en vue de dessus, un autre mode de réalisation d'un procédé selon l'invention, et
- la figure 23 représente, de manière schématique et en vue de coupe selon B-B, une étape d'un procédé selon le mode de réalisation de la figure 22.

### Description de modes particuliers de réalisation

Le procédé selon l'invention permet la réalisation d'un transistor à effet de champ sur un substrat comprenant une couche semi-conductrice, une couche diélectrique, une couche électriquement conductrice formant une contre-électrode ou un plan de masse, et une couche de support. La couche conductrice est isolée électriquement des autres couches par la couche diélectrique.

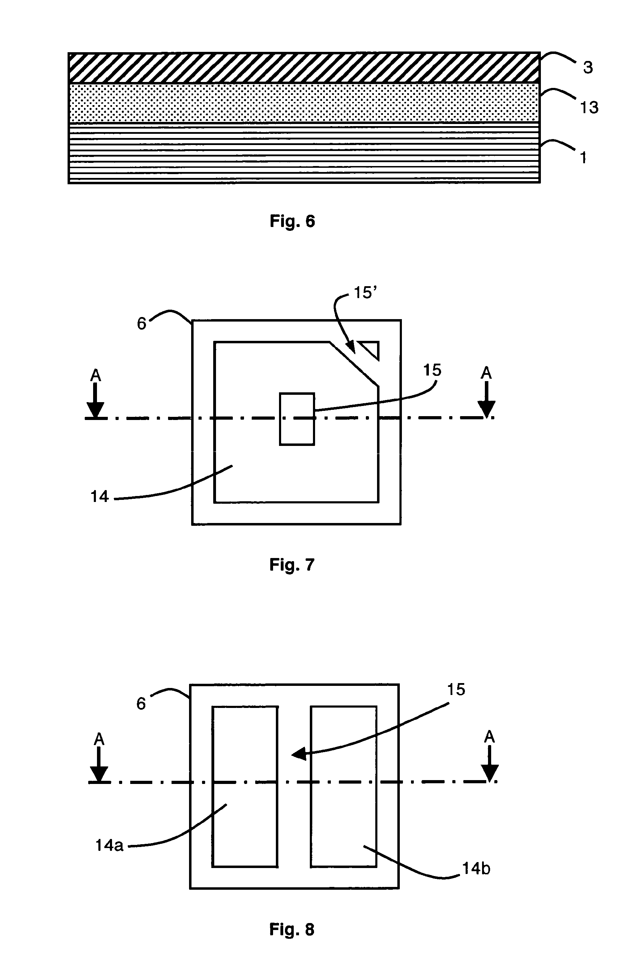

La figure 6 représente un substrat de départ comprenant la couche de support 1, une couche 13 dans un matériau sacrificiel et la couche semi-conductrice 3. La couche de support 1 est, par exemple, en silicium massif.

La couche sacrificielle 13 est, par exemple, en germanium, en silicium dopé, en oxyde de silicium SiO₂ ou en nitrure de silicium Si₃N₄. La couche sacrificielle 13 est, de préférence, en alliage de silicium-germanium SiGe. La couche SiGe 13 est formée, par exemple, par épitaxie sur la couche de support 1. La concentration en germanium varie, de préférence, entre 20% et 30% et l'épaisseur de la couche 13 SiGe est de l'ordre de 50nm. La couche semi-conductrice 3 est, par exemple, en silicium ou en alliage de silicium-germanium et est formée par épitaxie sur la couche sacrificielle 13. Son épaisseur est de l'ordre de 10nm. Pour l'ensemble des matériaux cités précédemment, il existe un procédé de gravure de la couche sacrificielle 13 de manière sélective par rapport à la couche semi-conductrice 3 et la couche de support 1.

Les figures 7 et 8 représentent en vue de dessus la disposition d'au moins une zone active 14 par rapport à un motif d'isolation 6.

La zone active, formée dans la couche semi-conductrice, est délimitée par un motif d'isolation périphérique fermé 6 de forme quelconque, par exemple un carré sur la figure 7. En d'autres termes, le motif d'isolation périphérique fermé 6 fixe les limites de la zone active. La zone active comporte également un motif additionnel 15 formé en même temps que le motif d'isolation périphérique fermé 6. Dans le mode de réalisation de la figure 7, le motif additionnel 15 est distinct du motif d'isolation 6, par exemple situé au centre du motif d'isolation 6.

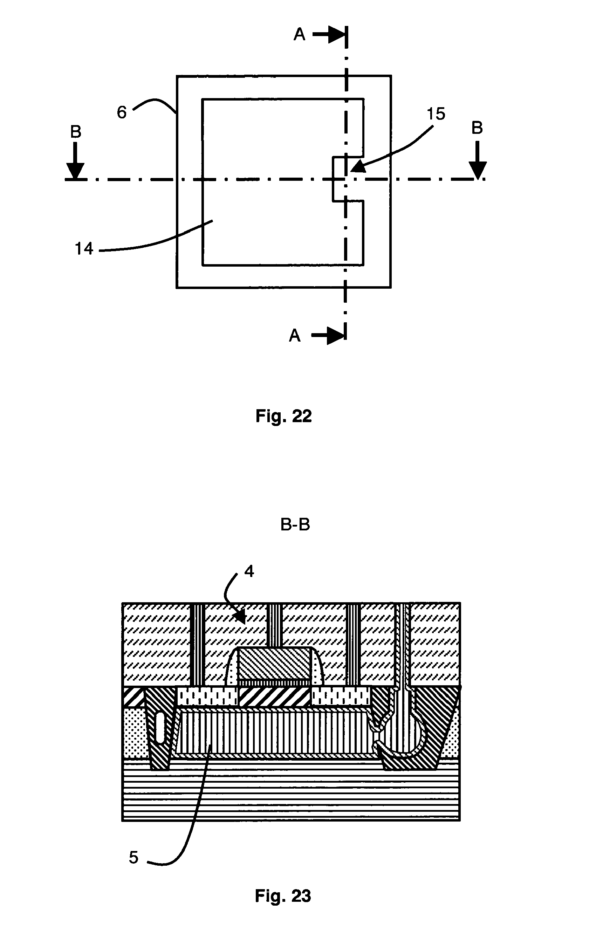

Les figures 8 et 22 représentent d'autres modes de réalisation pour la formation du motif d'isolation périphérique fermé 6 et du motif additionnel 15. Dans ces modes de réalisation, le motif additionnel 15 est en contact avec une partie du motif d'isolation 6 et prolonge cette partie. Le motif additionnel peut également être considéré comme faisant partie du motif d'isolation périphérique fermé 6.

Sur la figure 8, le motif additionnel 15 relie, par exemple, deux cotés opposés du motif 6. La zone active est divisée en deux zones actives 14a et 14b élémentaires, séparées latéralement par le motif 15. Les zones actives 14a et 14b sont isolées électriquement l'une de l'autre. Chaque zone active élémentaire (14a et 14b) peut alors comporter un transistor. Dans ce cas, les deux transistors partageront la même contre-électrode.

Le motif additionnel peut également relier deux côtés adjacents du motif 6, comme le motif 15' représenté sur la figure 7. Dans ce cas, les deux zones actives élémentaires formées n'ont pas la même utilisation. L'une des deux zones actives présente une surface insuffisante pour autoriser l'intégration d'un transistor MOS.

Dans les modes de réalisation en relation avec les figures 7 et 22, la zone active 14 est unique et ne peut donc comporter qu'un seul transistor.

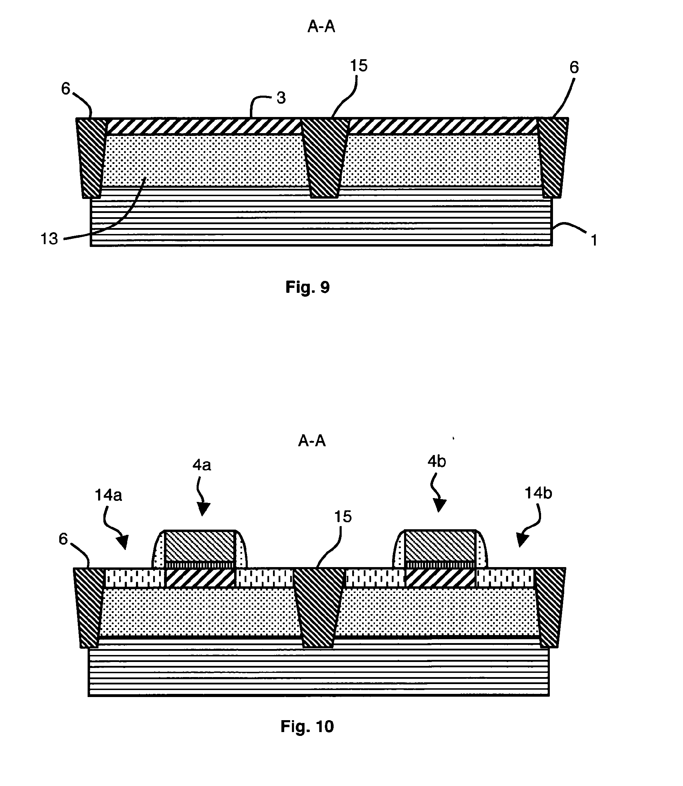

La figure 9 représente, selon la coupe A-A, une structure obtenue selon l'un des modes de réalisation des figures 7, 8 et 22. La structure fait apparaître deux zones de motif d'isolation 6 et une zone d'un motif additionnel 15.

Les motifs d'isolation 6 sont, de préférence, des tranchées d'isolation peu profondes (« Shallow Trench Isolation » en anglais, STI). Les tranchées sont formées par une étape de photolithographie puis une étape de gravure au travers de la couche semi-conductrice 3, de la couche sacrificielle 13 et une partie de la couche de support 1. Les tranchées sont ensuite remplies d'un matériau isolant électriquement, de l'oxyde de silicium par exemple ou un autre matériau tel que le nitrure de silicium.

Les figures 10 à 12 représentent des étapes d'un procédé standard de fabrication de transistors, ainsi que des contacts de source, de drain et de grille associés, après la formation des zones actives, dans le cas d'un motif délimitant deux zones actives.

La figure 10 représente une étape de formation d'au moins un transistor 4, par exemple un transistor sur chacune des zones actives 14a et 14b définies préalablement par la formation du motif périphérique 6 et du motif additionnel 15. Les transistors 4a et 4b sont formés dans la couche semi-conductrice 3. Avantageusement, les transistors 4a et 4b occupent entièrement les zones actives. Les transistors peuvent être de type partiellement déplétés ou complètement déplétés. Dans l'exemple de la figure 10, les transistors sont complètement déplétés, les canaux des transistors occupent donc toute l'épaisseur de la couche semi-conductrice. Les transistors sont réalisés de manière classique.

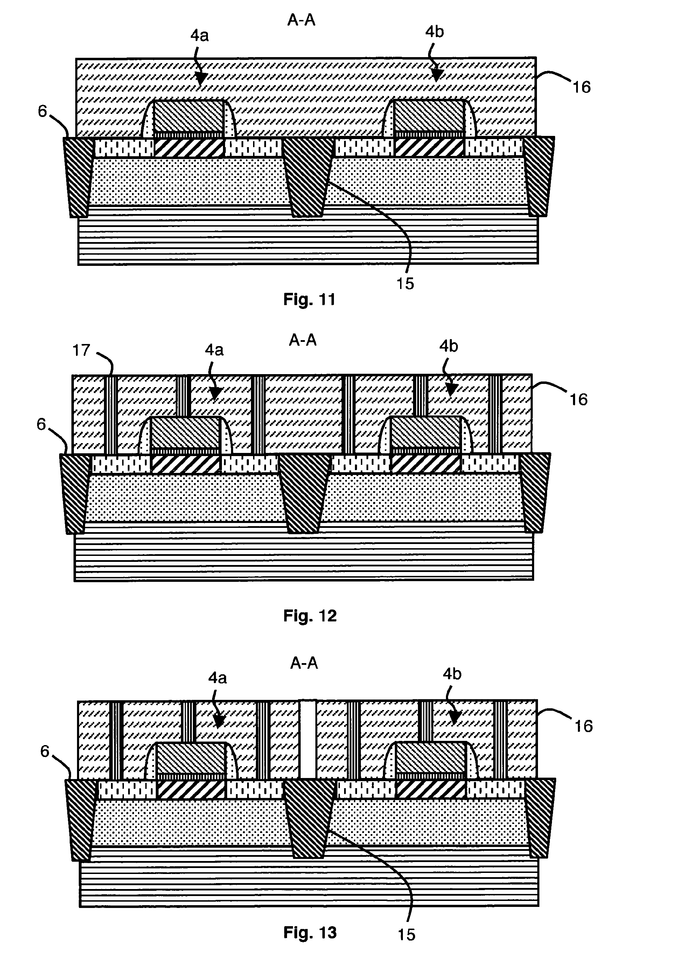

Comme illustré à la figure 11, les transistors 4a, 4b, le motif d'isolation 6 et le motif additionnel 15 sont recouverts par un matériau diélectrique d'interconnexion 16. De manière classique, le matériau diélectrique d'interconnexion 16 est choisi parmi les matériaux à faible constante diélectrique ou parmi les matériaux pouvant être éliminés pour former une structure à cavité d'air (« air gap » en anglais).

La figure 12 représente la formation de contacts 17 de drain, de source et de grille des transistors, par le dépôt d'un métal, après la gravure du matériau diélectrique d'interconnexion 16.

Comme représenté à ia figure 13, le matériau diélectrique d'interconnexion 16 est ensuite gravé pour accéder à une portion du motif additionnel 15, ici le motif central disposé entre les transistors 4a et 4b. Le procédé de gravure est, avantageusement, identique à celui utilisé pour graver le matériau diélectrique d'interconnexion 16 et définir les contacts 17. De préférence, le matériau diélectrique 16 est gravé en une seule fois pour définir les contacts 17 du transistor et réaliser cet accès au motif additionnel 15.

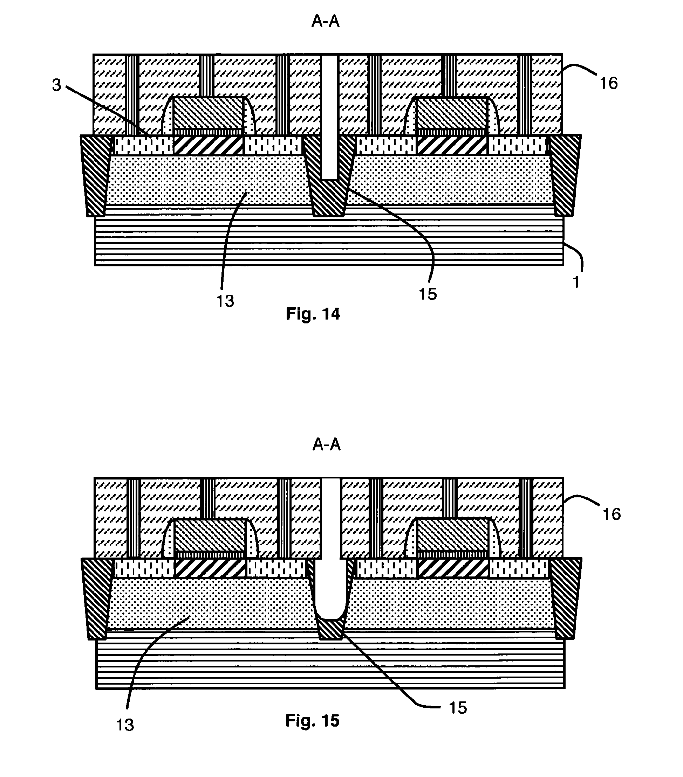

Les figures 14 et 15 représentent des étapes suivantes du procédé de réalisation, correspondant à la gravure du motif additionnel 15, au moins partiellement libéré par la gravure du matériau diélectrique d'interconnexion 16. Le motif additionnel 15 est gravé afin d'accéder à la couche sacrificielle 13 disposée entre la couche semi-conductrice 3 et la couche de support 1. L'accès peut être obtenu au moyen d'une gravure anisotrope et/ou une gravure isotrope du matériau constituant le motif additionnel 15.

La gravure du motif additionnel 15 est avantageusement réalisée en deux temps. Elle comprend une première étape de gravure anisotrope à travers une partie du motif additionnel 15, représentée à la figure 14, et une seconde étape de gravure isotrope du motif additionnel 15, représentée à la figure 15. La gravure anisotrope, réalisée par exemple par gravure plasma, atteint une région prédéfinie du motif additionnel 15. La gravure isotrope atteint les bords du motif 15 en contact avec la couche sacrificielle 13, et ainsi autorise l'accès à la couche sacrificielle. La gravure isotrope est, par exemple, réalisée par une gravure humide, à base d'acide fluorhydrique dans le cas de motifs 15 à base de silice. La profondeur gravée lors de la gravure anisotrope et l'épaisseur éliminée par la gravure isotrope dépendent des contraintes géométriques liées au motif additionnel 15 et du volume de matériau constituant la couche sacrificielle 13 à éliminer et à remplir par la suite. Par exemple, il peut être nécessaire de former une zone d'accès à la couche sacrificielle importante pour graver cette couche rapidement.

Dans un mode particulier de réalisation (non représenté) qui reprend les étapes technologiques illustrées jusqu'à la figure 13, une seule gravure isotrope est utilisée pour accéder à la couche sacrificielle. Une zone supérieure seulement du motif additionnel 15 est ainsi gravée pour autoriser l'accès à la couche sacrificielle. Il est avantageux d'utiliser une gravure sélective par rapport au matériau diélectrique 16 pour ne pas éliminer trop de matériau 16 autour des contacts 17.

Dans un mode de réalisation préféré, la gravure du matériau diélectrique 16 et la première étape de gravure anisotrope du motif 15 sont réalisées en une seule fois. Ainsi, la gravure anisotrope est réalisée à travers le matériau diélectrique d'interconnexion 16 et une partie du motif additionnel 15.

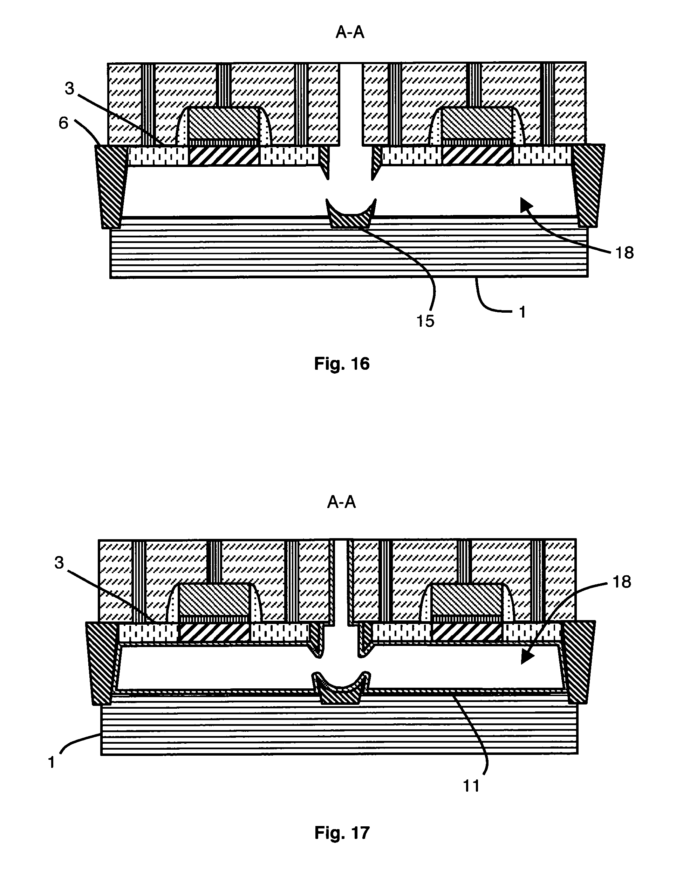

La figure 16 représente l'étape de gravure de la couche sacrificielle d'où il résulte une première cavité 18, après la gravure du motif additionnel 15. La première cavité 18 est remplie ultérieurement par le matériau formant la contre-électrode. La gravure peut être partielle, en laissant par exemple une épaisseur variable de matériau sacrificiel sur les faces latérales des motifs d'isolation 6. La couche sacrificielle 13 peut également être gravée en totalité.

Dans le cas d'une couche sacrificielle 13 en alliage de silicium et germanium SiGe, la gravure sélective de la couche 13 par rapport à la couche semi-conductrice 3, à la couche de support 1 et au motif d'isolation 6 est réalisée, par exemple, par gravure plasma ou par vapeur du chlorure d'hydrogène HCl. Dans le cas d'une couche sacrificielle 13 en silicium, la gravure plasma peut être utilisée à condition que la couche sacrificielle comporte de plus une couche d'arrêt, par exemple en SiGe. La première cavité 18 formée est auto-alignée sur les faces latérales des motifs d'isolation 6 s'il y a gravure complète de la couche sacrificielle.

Dans une variante de réalisation, une couche de matériau de protection est avantageusement formée à l'interface entre le motif d'isolation périphérique et la couche sacrificielle. La couche de protection recouvre au moins une face extérieure du motif d'isolation exposée à la gravure de la couche sacrificielle. De préférence, la couche de protection recouvre les faces latérales et la face inférieure du motif d'isolation périphérique. Cette couche de protection est réalisée lors de la formation du motif d'isolation, en déposant le matériau de protection sur le fond et les parois latérales de la tranchée. Le matériau de protection est, par exemple, le nitrure de silicium si la couche sacrificielle est en SiO₂. La couche de protection a une épaisseur de l'ordre de quelques nanomètres.

Le matériau de protection est avantageux car il forme une couche d'arrêt de la gravure de la couche sacrificielle, par exemple si la couche sacrificielle est en oxyde de silicium et gravée par HF. La cavité formée est également auto-alignée sur les faces latérales des motifs d'isolation. La couche de protection est nécessaire si la couche sacrificielle est dans le même matériau que les motifs d'isolation. Le motif d'isolation périphérique étant formé en même temps que le motif additionnel, ce dernier comporte également la couche de protection. Alors, la gravure du motif 15 comporte une troisième étape d'élimination du matériau de protection avant élimination de la couche sacrificielle.

La figure 17 représente la formation de la couche diélectrique 11 sur au moins une paroi supérieure de la première cavité 18 c'est-à-dire sur la surface inférieure de la couche 3. La couche diélectrique peut également recouvrir toutes les parois de la première cavité 18. Une première technique pour former cette couche 11 consiste à venir déposer au moins un matériau isolant sur les parois de la première cavité 18. Le matériau isolant est, par exemple, de l'oxyde de silicium SiO₂. L'épaisseur de la couche 11 est, par exemple, de l'ordre de 10nm. L'épaisseur de la couche diélectrique 11 est variable afin de positionner la contre-électrode par rapport aux transistors. De cette manière, on choisit de moduler avec la contre-électrode le corps et/ou la source et/ou la drain du transistor. Le dépôt du matériau isolant de la couche diélectrique 11 est réalisé par toute technique adaptée, avantageusement par PECVD avec une température compatible avec le budget thermique imposé par les transistors déjà formés. Une seconde technique peut être l'oxydation thermique de la fine couche sacrificielle restante ou d'une partie de la couche semi-conductrice 3 et éventuellement de la couche de support 1 dans le cas où le budget thermique l'autorise. Une combinaison de ces oxydations thermiques est également possible.

Dans une variante de réalisation, la couche sacrificielle est formée à l'aide d'un premier matériau sacrificiel et d'un second matériau sacrificiel. Le premier matériau sacrificiel est disposé sur le second matériau sacrificiel. Le second matériau sacrificiel est gravé pour former la première cavité et le premier matériau sacrificiel forme, après une étape d'oxydation thermique, la couche diélectrique. Le premier matériau est, par exemple, du silicium-germanium et le second matériau, du silicium. Dans ce cas, le matériau diélectrique 11 est localisé uniquement sous la couche semi-conductrice 3 sur toute la surface de la zone active. Si la couche de support 1 est électriquement conductrice, il faut également isoler la contre-électrode de la couche 1 par un matériau isolant, par exemple par l'oxydation du premier matériau sacrificiel disposé également sous le second matériau sacrificiel.

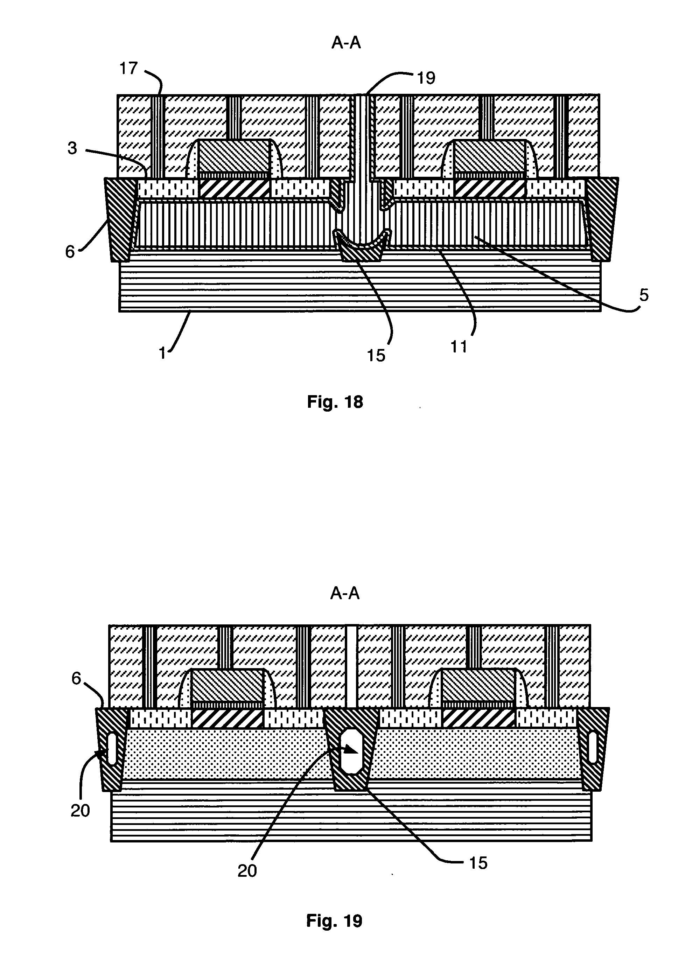

La figure 18 représente le dépôt de la couche électriquement conductrice dans la première cavité restante, formant ainsi la contre-électrode 5 du transistor. La couche conductrice peut être constituée d'un matériau métallique (W, Ti, TiN, TaN, Cu) ou d'un semi-conducteur dopé, de type n ou p, le polysilicium par exemple.

Avantageusement, le matériau formant la contre-électrode 5 est identique au matériau formant les contacts 17 de drain, de source et de grille des transistors. Dans un autre mode de réalisation, la formation des contacts 17 des transistors peut avoir lieu en même temps que le dépôt de la couche électriquement conductrice, à travers le matériau diélectrique d'interconnexion. De même, un contact 19 de la contre-électrode 5 peut être formé simultanément avec le dépôt de la couche électriquement conductrice. A titre d'exemple, après l'étape de gravure du matériau diélectrique 16 représentée à la figure 12, un bouchon peut être disposé sur la surface du matériau diélectrique 16 sans avoir fait le dépôt de métal. Ce bouchon est retiré après formation de la première cavité 18 et dépôt de la couche diélectrique 11 pour effectuer le dépôt simultané des contacts 17 et de la contre-électrode 5. La gravure du matériau diélectrique 16 pour ouvrir les contacts du transistor peut également être reportée après la formation de la première cavité 18 et formation de la couche 11.

Un matériau métallique pour les contacts et la couche électriquement conductrice est préféré. Le dépôt de métal est rendu possible par le fait que le transistor a été formé puis recouvert par le matériau diélectrique d'interconnexion après la formation de la zone active et avant la gravure du motif additionnel. Le risque de contamination des équipements par ce métal est donc réduit.

On pourra cependant envisager un mode de réalisation dans lequel le transistor est formé après la gravure de la couche sacrificielle et le dépôt de la contre-électrode formée par un semi-conducteur dopé par exemple. L'homme du métier adaptera alors l'ordre des étapes de fabrication.

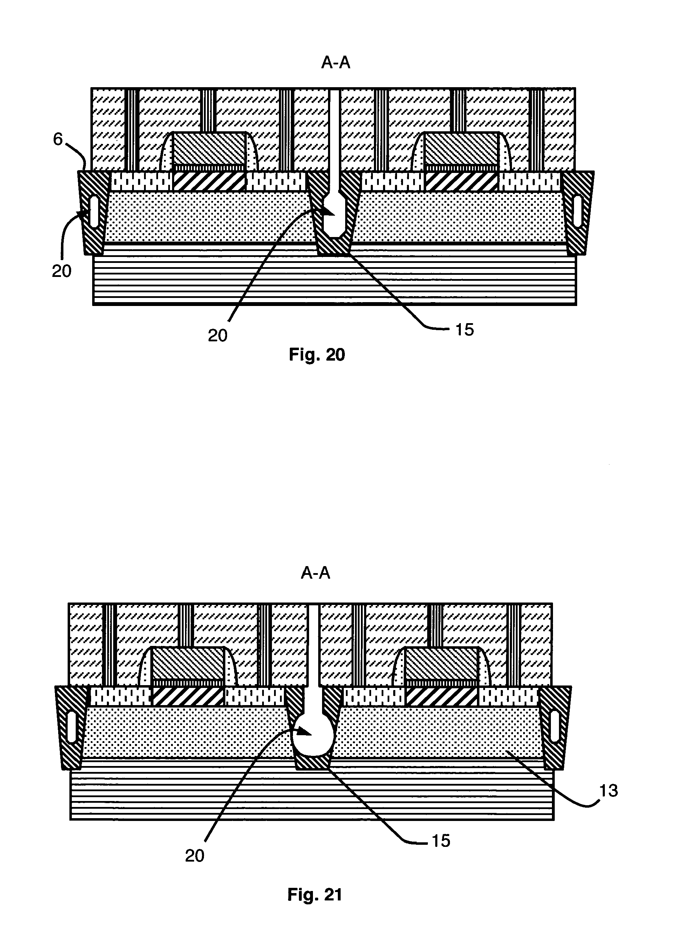

Les figures 19 à 21 représentent une variante de réalisation du procédé qui correspond respectivement aux étapes illustrées sur les figures 13 à 15. Dans ce mode de réalisation préféré, la formation de la zone active est prévue pour favoriser la constitution de secondes cavités 20 dans le motif d'isolation périphérique fermé 6 et le motif additionnel 15. La seconde cavité 20 peut être formée pendant la réalisation des motifs 6 et 15, en contrôlant l'épaisseur du matériau isolant déposé au fond et sur les flancs des motifs. La gravure anisotrope débouche alors sur la seconde cavité 20 du motif additionnel 15, comme représenté sur la figure 20. La gravure isotrope (Fig.21) élargit la seconde cavité 20 jusqu'à ce qu'elle atteigne l'interface entre la couche sacrificielle 13 et le motif 15.

Comme décrit précédemment, la gravure isotrope du motif 15 peut être réalisée dans un bain d'acide fluorhydrique HF. La présence de la seconde cavité 20 à l'intérieur du motif est avantageuse car elle permet alors de réduire le temps de gravure. Ceci est particulièrement bénéfique quand le matériau diélectrique d'interconnexion 16 et le matériau isolant constituant le motif additionnel 15 réagissent au même procédé de gravure isotrope. La gravure isotrope du matériau diélectrique d'interconnexion 16 est alors limitée. Un temps de gravure restreint est également bénéfique pour éviter d'éliminer complètement le matériau isolant constituant le motif additionnel 15.

Avantageusement, le motif additionnel 15 a, dans un plan parallèle au substrat, des dimensions longitudinale et transversale supérieures à la plus petite des dimensions longitudinale et transversale du motif d'isolation périphérique fermé 6. De cette manière, la seconde cavité 20 formée à l'intérieur du motif additionnel 15 est plus grande que la seconde cavité 20 formée à l'intérieur du motif d'isolation périphérique fermé 6 (Fig.19). L'épaisseur gravée de façon isotrope est ainsi diminuée comparé au mode de réalisation précédent pour atteindre la couche sacrificielle 13. Le reste du procédé est réalisé comme précédemment.

La figure 22 représente une autre position du motif additionnel 15 par rapport au motif d'isolation périphérique fermé 6. Dans ce mode de réalisation, la zone active 14 est délimitée par un motif périphérique fermé 6. Le motif périphérique 6 présente une partie en saillie dirigée vers la zone active. Cette partie en saillie forme le motif additionnel 15. L'accès à la couche sacrificielle est réalisé au moyen du motif 15, comme décrit en relation avec les figures 13 à 15. Cependant, il est nécessaire de prendre des précautions supplémentaires lors de la gravure du motif additionnel 15, car ce dernier est en contact direct avec le motif 6 qui assure l'isolation avec la zone active adjacente. Le motif additionnel 15 est alors gravé, de préférence, en laissant intact le motif 6.

Les figures 9 à 21 représentent, en coupe selon A-A, la structure obtenue pendant des étapes du procédé, selon le mode de réalisation de la figure 22, tandis que la figure 23 représente, en coupe selon B-B, la structure finale selon le mode de réalisation de la figure 22. Le mode de réalisation des figures 22 et 23 est, par exemple, avantageux lorsqu'un seul transistor 4 est formé sur la zone active et donc dédié à une contre-électrode 5.

Le procédé permet d'obtenir avec facilité un dispositif semi-conducteur comprenant une pluralité de transistors adjacents sur un substrat. Il n'est pas utilisé d'implantation ionique ni d'étapes de photolithographie spécifiques à cette implantation comme dans l'art antérieur. Ainsi, on évite les problèmes de désalignement et le problème d'amorphisation de la couche semi-conductrice.

Le dispositif final, représenté à la figure 23 selon le mode de réalisation de la figure 22 ou en relation avec le mode de réalisation de la figure 7 comporte une contre-électrode 5 et un transistor 4 associé à une zone active 14.

Dans ces modes de réalisation, chaque transistor est formé sur une zone active et comprend un plan de masse. La zone active et le plan de masse de chaque transistor sont délimités par un même motif d'isolation périphérique fermé. Ainsi, le potentiel imposé par le plan de masse est uniforme sur l'ensemble de la zone active, ce qui limite davantage les effets de canaux courts et améliore le contrôle électrostatique du canal. Le dispositif comporte un motif additionnel en matériau isolant à l'intérieur de la surface délimitée par le motif périphérique fermé pour former un contact du plan de masse.

Ce dispositif est avantageux car les risques de fuites entre les plans de masse sont évités. En effet, chaque plan de masse est délimité par le motif d'isolation périphérique fermé. De plus, le motif additionnel, traversé par le contact de plan de masse, est compris à l'intérieur de la surface délimitée par le motif périphérique fermé et s'enfonce jusqu'à une couche de support, disposée sous le plan de masse 5. Cela permet d'obtenir un dispositif ayant une densité d'intégration des transistors élevée.

Dans le cas des figures 8 et 18, le dispositif comprend un premier transistor formé sur une zone active 14a et un second transistor formé sur une zone active 14b. Les zones actives sont séparées par le motif additionnel 15 et associées à un même plan de masse 5. Les zones actives 14a et 14b et le plan de masse sont délimités par le motif d'isolation périphérique fermé 6 et par le motif additionnel 15. Le motif additionnel 15 est disposé à l'intérieur de la surface délimitée par le motif périphérique fermé 6 pour former le contact du plan de masse 5.

## Revendications

1. Procédé de réalisation d'un transistor à effet de champ sur un substrat comprenant une couche de support (1), une couche sacrificielle (13) et une couche semi-conductrice (3), procédé comprenant :
- la formation d'une zone active (14) dans la couche semi-conductrice, la zone active étant délimitée par un motif d'isolation périphérique fermé (6) et comportant un motif additionnel (15,15') dans un matériau isolant,
- la gravure du matériau isolant du motif additionnel (15,15') pour accéder à la couche sacrificielle (13),
- la gravure de la couche sacrificielle d'où il résulte la formation d'une première cavité (18),
- la formation d'une couche diélectrique (11) sur une paroi supérieure de la première cavité, et
- le dépôt d'une couche électriquement conductrice (5) dans la première
cavité,
procédé **caractérisé en ce que** le motif d'isolation (6) est formé au travers de la couche semi-conductrice (3) et de la couche sacrificielle (13).

2. Procédé selon la revendication 1, **caractérisé en ce que** la gravure du matériau isolant du motif additionnel (15,15') est réalisée en laissant intact le motif d'isolation périphérique fermé (6).

3. Procédé selon l'une des revendications 1 et 2, **caractérisé en ce qu'**il comporte, après la formation de la zone active (14) et avant la gravure du motif additionnel (15,15'), la formation d'un transistor (4) sur la zone active et le recouvrement du transistor par un matériau diélectrique d'interconnexion (16).

4. Procédé selon la revendication 3, **caractérisé en ce que** la gravure du motif additionnel (15,15') comprend une première étape de gravure anisotrope à travers le matériau diélectrique d'interconnexion (16) et une partie du motif additionnel, et une seconde étape de gravure isotrope du motif additionnel.

5. Procédé selon l'une quelconque des revendications 1 à 4, **caractérisé en ce que** la formation de la zone active est prévue pour favoriser la constitution de secondes cavités (20) dans le motif d'isolation périphérique fermé (6) et le motif additionnel (15,15').

6. Procédé selon l'une quelconque des revendications 1 à 5, **caractérisé en ce qu'**il comporte la formation d'une couche de matériau de protection à l'interface entre le motif d'isolation périphérique fermé (6) et la couche sacrificielle (13).

7. Procédé selon l'une quelconque des revendications 3 à 6, **caractérisé en ce qu'**il comporte la formation de contacts (17) du transistor (4) en même temps que le dépôt de la couche électriquement conductrice, à travers le matériau diélectrique d'interconnexion (16).

8. Procédé selon l'une quelconque des revendications 1 à 7, **caractérisé en ce qu'**il comporte la formation de la couche sacrificielle (13) à l'aide d'un premier matériau sacrificiel et d'un second matériau sacrificiel, le premier matériau sacrificiel formant la couche diélectrique (11) et le second matériau sacrificiel étant gravé pour former la première cavité (18).

9. Dispositif semi-conducteur comportant une pluralité de transistors (4) sur un substrat, chaque transistor étant formé sur une zone active (14) et étant associé à un plan de masse (5), **caractérisé en ce que** la zone active et le plan de masse sont délimités par un même motif d'isolation périphérique fermé (6) et **en ce qu'**il comporte, pour chaque transistor, un motif additionnel (15,15') à l'intérieur de la surface délimitée par le motif périphérique fermé (6) pour former un contact du plan de masse.

10. Dispositif selon la revendication 9, **caractérisé en ce que** le motif additionnel (15,15') a des dimensions longitudinale et transversale supérieures à la plus petite des dimensions longitudinale et transversale du motif d'isolation périphérique fermé (6), dans un plan parallèle au substrat.

11. Dispositif selon la revendication 9, **caractérisé en ce que** le motif d'isolation périphérique fermé (6) présente une partie en saillie dirigée vers la zone active (14), le motif additionnel (15) étant formé par la partie en saillie.

12. Dispositif semi-conducteur comportant deux transistors (4) associés à un même plan de masse (5), chaque transistor étant formé sur une zone active (14a, 14b), **caractérisé en ce que** les zones actives et le plan de masse sont délimités par un même motif d'isolation périphérique fermé (6) et par un motif additionnel (15,15'), le motif additionnel étant disposé à l'intérieur de la surface délimitée par le motif périphérique fermé (6) pour former un contact du plan de masse.
